(19) Europäisches Patentamt
European Patent Office
Office européen des brevets

(11) **EP 4 130 309 A1**

(12) **EUROPEAN PATENT APPLICATION**
published in accordance with Art. 153(4) EPC

(43) Date of publication:
**08.02.2023 Bulletin 2023/06**

(21) Application number: **21775180.9**

(22) Date of filing: **05.03.2021**

(51) International Patent Classification (IPC):
**C22C 9/00** (1968.09)     **C22C 26/00** (1985.01)

(52) Cooperative Patent Classification (CPC):
**C22C 9/00; C22C 26/00**

(86) International application number:
**PCT/JP2021/008634**

(87) International publication number:
**WO 2021/192916 (30.09.2021 Gazette 2021/39)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **24.03.2020 JP 2020053219**

(71) Applicants:
• **Sumitomo Electric Industries, Ltd.**
  **Osaka-shi, Osaka 541-0041 (JP)**
• **A.L.M.T. Corp.**
  **Minato-ku**
  **Tokyo 105-0014 (JP)**

(72) Inventors:
• **MATSUGI, Ryota**
  **Osaka-shi, Osaka 541-0041 (JP)**
• **IWAYAMA, Isao**
  **Osaka-shi, Osaka 541-0041 (JP)**
• **NISHIMIZU, Takahiro**
  **Sakata-shi, Yamagata 998-0114 (JP)**
• **SOTA, Chieko**
  **Toyama-shi, Toyama 931-8543 (JP)**

(74) Representative: **Boult Wade Tennant LLP**
**Salisbury Square House**
**8 Salisbury Square**
**London EC4Y 8AP (GB)**

(54) **COMPOSITE MATERIAL AND HEAT DISSIPATION MEMBER**

(57)     A composite material including a metallic phase and plurality of particles dispersed in the metallic phase. The plurality of particles is a carbon-based material; the metallic phase contains a main element, a first element, and a second element; the coating layer of each of the plurality of particles is carbide of the second element. The main element is copper; the first element is a metallic element having a lower surface tension than copper; the second element is at least one selected from the group consisting of beryllium, silicon, titanium, chromium, zirconium, niobium, hafnium, and tantalum. The content of the first element based on the sum of the main element, the first element, and the second element is 0.25 atom% or more and 10.0 atom% or less, and the content of the second element based on the sum of the main element, the first element, and the second element is 1.5 atom% or more and 14.0 atom% or less.

FIG.1

EP 4 130 309 A1

**Description**

TECHNICAL FIELD

The present disclosure relates to a composite material and a heat dissipation member. The present application claims priority based on Japanese Patent Application No. 2020-053219, filed March 24, 2020, the contents of which are incorporated herein by reference in their entirety.

BACKGROUND ART

Heat dissipation members of semiconductor devices include heat spreaders, heat sinks, and the like. Composite materials of carbon-based materials such as diamond and metals have been known as suitable materials for such heat dissipation members. The composite material includes a metallic phase and a plurality of particles dispersed in the metallic phase. Each of the plurality of particles (each particle) is composed of a carbon-based material such as diamond excellent in thermal conductivity. Each particle includes a coating layer composed of carbide on the surface thereof. The coating layer improves the wettability between the particles and the metallic phase and inhibits formation of voids in the composite material.

Examples of the metallic phase of the composite material above include metallic phases described in PTLs 1 to 3. The metallic phase in a composite material of PTL 1 is composed of a eutectic alloy of silver (Ag) and copper (Cu). Since the eutectic alloy contains about 72% by mass of Ag, it can be said to be an alloy composed mainly of Ag. The metallic phase in a composite material of PTL 2 is composed mainly of Ag. The metallic phase in a composite material of PTL 3 is composed mainly of Cu.

CITATION LIST

PATENT LITERATURE

PTL 1: Japanese Patent Laying-Open No. 2004-197153
PTL 2: WO2016/035795
PTL 3: WO2019/163721

SUMMARY OF INVENTION

The composite material of the present disclosure is a composite material including:

a metallic phase; and
a plurality of particles dispersed in the metallic phase, each of the plurality of particles (each particle) having a coating layer covering a surface of each of the particles (each particle), wherein
the plurality of particles is a carbon-based material;
the metallic phase includes a main element, a first element, and a second element;
the coating layer is carbide of the second element;
the main element is copper;
the first element is a metallic element having a lower surface tension than copper;
the second element is at least one selected from the group consisting of beryllium, silicon, titanium, chromium, zirconium, niobium, hafnium, and tantalum;
a content of the first element based on a sum of the main element, the first element, and the second element is 0.25 atom% or more and 10.0 atom% or less, and
a content of the second element based on a sum of the main element, the first element, and the second element is 1.5 atom% or more and 14.0 atom% or less.

The heat dissipation member of the present disclosure includes:

a substrate composed of the composite material of the present disclosure; and
a copper layer covering at least a portion of a surface of the substrate.

BRIEF DESCRIPTION OF DRAWINGS

Fig. 1 is a schematic view of the cross section of the composite material according to one embodiment.
Fig. 2 is a schematic view of the surface of particles in the composite material shown in Fig. 1.
Fig. 3 is a schematic configuration view of the heat dissipation member according to another embodiment.

DETAILED DESCRIPTION

[Problem to be Solved by the Present Disclosure]

Since the coefficient of linear expansion of Cu is lower than that of Ag, the main component of the metallic phase of a composite material is preferably Cu rather than Ag from the viewpoint of lowering the coefficient of linear expansion of the composite material. Moreover, Cu also has advantages of being lighter than Ag and less expensive than Ag. Therefore, a composite material including a metallic phase composed mainly of Cu has been desired.
Here, the composite material used for a heat dissipation member, is sometimes required to have heat resistance at elevated temperatures in addition to excellent thermal conductivity. For example, when soldering a ceramic frame member to the substrate composed of a composite material, an Ag-Cu alloy solder material is used. It is necessary for the composite material not to deform at a temperature at which the solder material melts. From the viewpoint of this, the composite material of PTL 1, which has a metallic phase composed mainly of Ag-Cu alloy, has room for improvement in terms of heat resistance. This is because the melting point of the Ag-Cu alloy that constitutes the metallic phase is close to that of a solder material.
On the other hand, the melting point of Cu is higher than that of the Ag-Cu alloy, and therefore the composite material having the metallic phase composed mainly of Cu is excellent in heat resistance. However, even particles of a carbon-based material with the coating layer that improves wettability between particles and the metallic phase, the wettability between the particles of the carbon-based material and Cu is not favorable. Therefore, when a plurality of particles composed of a carbon-based material and Cu are composited, the composite material facilitates formation of a plurality of voids. These voids may reduce the thermal conductivity of the composite material.
Thus, an object of the present disclosure is to provide a composite material excellent in thermal conductivity and heat resistance. Another one object of the present disclosure is to provide a heat dissipation member excellent in heat dissipation and heat resistance.

[Advantageous Effect of the Present Disclosure]

The composite material of the present disclosure is excellent in thermal conductivity and heat resistance. The heat dissipation member of the present disclosure is excellent in heat dissipation and heat resistance.

[Description of Embodiments]

The composite material is obtained by compositing a plurality of particles of a carbon-based material with molten metal that serves as a raw material for a metallic phase. The present inventors have diligently investigated a configuration to improve the wettability between the particles of the carbon-based material and the metallic phase in the composite material including the metallic phase composed mainly of Cu. As a result, the present inventors have found that the wettability between the particles of the carbon-based material and the metallic phase can be improved by containing an element having a lower surface tension than Cu in the molten metal of the metallic phase. In the molten metal containing a first element having a lower surface tension than Cu, the first element is easily concentrated on the surface of the molten metal in contact with the particles. This first element is considered to improve the wettability between the particles of the carbon-based material and the molten metal. Based on this finding, the present inventors have completed the composite material according to the present embodiment. First, embodiments of the present disclosure will be listed and then described. Here, an aggregate of the plurality of particles of the carbon-based material as used herein is referred to as "carbon-based powder."
<1> The composite material according to the present embodiment includes:

a metallic phase; and
a plurality of particles dispersed in the metallic phase, each of the plurality of particles having a coating layer covering a surface of each of the particles, wherein
the plurality of particles is a carbon-based material;

the metallic phase comprises a main element, a first element, and a second element;
the coating layer is carbide of the second element;
the main element is copper;
the first element is a metallic element having a lower surface tension than copper;
the second element is at least one selected from the group consisting of beryllium, silicon, titanium, chromium, zirconium, niobium, hafnium, and tantalum;
a content of the first element based on a sum of the main element, the first element, and the second element is 0.25 atom% or more and 10.0 atom% or less, and
a content of the second element based on a sum of the main element, the first element, and the second element is 1.5 atom% or more and 14.0 atom% or less.

Here, the main element is a metallic element that is a main component of the metallic phase, i.e., a metallic element that occupies the majority of the metallic phase.

The composite material of <1> above includes the following composition:

[The composite material includes:

a metallic phase; and
a plurality of particles dispersed in the metallic phase, each of the plurality of particles having a coating layer covering a surface of each of the particles, wherein
each of the particles is a carbon-based material; and
components excluding carbon contain
0.25 atom% or more and 10.0 atom% or less of the first element, and
1.5 atom% or more and 14.0 atom% or less of the second element,
with the balance being copper and unavoidable impurities, wherein
the first element is a metallic element having a lower surface tension than copper; and
the second element is at least one selected from the group consisting of beryllium, silicon, titanium, chromium, zirconium, niobium, hafnium, and tantalum.]

The composite material according to the present embodiment is excellent in thermal conductivity.

The particle of a carbon-based material represented by diamond, is excellent in thermal conductivity. Moreover, Cu that is the main component of the metallic phase, is excellent in thermal conductivity. Therefore, the composite material according to the present embodiment is excellent in thermal conductivity.

Furthermore, on the surface of each of the plurality of particles (each particle) in the composite material according to the present embodiment is arranged the coating layer composed of carbide of the second element. This coating layer improves the wettability between the particles and the molten metal of the metallic phase upon fabrication of the composite material. Moreover, the metallic phase in the composite material contains the first element having a lower surface tension than Cu. This first element is concentrated on the surface of the molten metal of the metallic phase upon fabrication of the composite material and improves the wettability between the molten metal of the metallic phase and the particles. Due to improvement on the wettability by the coating layer and improvement on the wettability by the first element, voids are unlikely to be formed in the composite material. Therefore, the composite material according to the present embodiment is excellent in thermal conductivity.

The composite material according to the present embodiment is excellent in heat resistance.

The metallic phase in the composite material according to the present embodiment is mainly composed of Cu, which has a higher melting point than an Ag alloy. Therefore, when the composite material is soldered with ceramics or the like, the composite material is unlikely to be deformed at temperatures in the vicinity of the melting point of the solder material.

The composite material according to the present embodiment has a small coefficient of linear expansion.

The coefficient of linear expansion of Cu is smaller than that of Ag.
Therefore, the coefficient of linear expansion of the composite material of the present embodiment including the metallic phase composed mainly of Cu, tends to be lower than that of the composite material including the metallic phase composed mainly of Ag. The coefficient of linear expansion of the composite material including the metallic phase composed mainly of Cu is close to coefficients of linear expansion of heating elements such as semiconductor devices. Therefore, the delamination between the composite material and the heating element due to the difference in coefficient of linear expansion is facilitated to be inhibited.

The composite material according to the present embodiment is inexpensive and lightweight.

The metallic phase in the composite material according to the present embodiment contains Cu as the main element. Cu is lighter and less expensive than Ag. Therefore, the composite material of the present disclosure is lighter and less expensive than the composite material mainly composed of Ag.

<2> As a form of the composite material according to the present embodiment, mention may be made to a form in which

the carbon-based material is diamond.

Diamond is extremely excellent in thermal conductivity. Therefore, the particles composed of diamond and dispersed in a metallic phase improves the thermal conductivity of the composite material. Moreover, diamond powder with various particle sizes is commercially available, and the diamond powder is readily available.

<3> As a form of the composite material according to the present embodiment, mention may be made to a form in which

the first element is at least one selected from the group consisting of silver, magnesium, aluminum, tin, zinc, and manganese.

Surface tension of each molten metal of Ag, magnesium (Mg), aluminum (Al), tin (Sn), zinc (Zn), and manganese (Mn) is smaller than that of the molten metal of Cu. Moreover, the metals listed in <3> above are readily available.

<4> As a form of the composite material described in <3> above, mention may be made to a form in which the first element is silver.

Ag is excellent in the wettability with particles having a coating layer. Therefore, Ag is suitable as the first element contained in the metallic phase.

<5> As a form of the composite material according to the present embodiment, mention may be made to a form in which

the second element is titanium.

The second element is at least one selected from the group consisting of beryllium (Be), silicon (Si), titanium (Ti), chromium (Cr), zirconium (Zr), niobium (Nb), hafnium (Hf), and tantalum (Ta). Among these second element candidates, Ti is readily available. Moreover, titanium carbide facilitates the wettability of the molten metal of a metallic phase for the particles composed of the carbon-based material to be improved.

<6> As a form of the composite material according to the present embodiment, mention may be made to a form in which

the content of the plurality of particles is 40% by volume or more and 80% by volume or less.

In a case in which the content of the carbon-based powder that is superior in thermal conductivity than the metallic phase, is within the above range, a composite material excellent in thermal conductivity can be obtained. Further, not too much carbon-based powder upon production of the composite material facilitates the molten metal of the metallic phase to be infiltrated between the particles of the carbon-based powder, thus enabling a composite material with fewer voids and excellent in thermal conductivity to be obtained.

<7> As a form of the composite material according to the present embodiment, mention may be made to a form in which

the plurality of particles includes a plurality of fine particles and a plurality of coarse particles,
each of the plurality of fine particles has a particle size of less than 30 $\mu$m,
each of the plurality of coarse particles has a particle size of 30 $\mu$m or larger, and
a volume fraction of the plurality of fine particles based on all particles of the plurality of particles is 20% by volume or more and 50% by volume or less.

The carbon-based powder being a mixture of the plurality of fine particles and the plurality of coarse particles facilitates the content of the carbon-based powder in the composite material to be increased. In particular, the volume fraction of the plurality of fine particles based on all the particles of the plurality of particles within the above range facilitates the content of the carbon-based powder in the composite material to be high.

<8> The heat dissipation member of the present embodiment includes:

a substrate composed of the composite material described in any of <1> to <7> above; and
a copper layer covering at least a portion of a surface of the substrate.

The heat dissipation member according to the present embodiment is excellent in heat dissipation.

The substrate included in the heat dissipation member according to the present embodiment is composed of the composite material according to the aforementioned embodiment. The particles of the carbon-based material contained in the composite material and Cu that is a main component of the metallic phase are excellent in thermal conductivity. Therefore, the heat dissipation member according to the present embodiment including the substrate composed of the composite material according to the aforementioned embodiment can effectively dissipate the heat of a heating element such as a semiconductor device.

The heat dissipation member according to the present embodiment is suitable as a heat dissipation member for semiconductor devices.

The substrate of the composite material included in the heat dissipation member according to the present embodiment has an intermediate coefficient of linear expansion between those of a carbon-based substance and Cu. The coefficient of linear expansion of this substrate is close to coefficients of linear expansion of semiconductor devices, coefficients of linear expansion of insulating substrates and the like for semiconductor devices. Therefore, when semiconductor devices are used, the delamination between the semiconductor device and the heat dissipation member due to the difference in coefficient of linear expansion is inhibited.

The heat dissipation member according to the present embodiment facilitates bonding to heating elements such as semiconductor devices.

The heat dissipation member according to the present embodiment includes a copper layer at least on a portion of the surface of a substrate. Since the copper atoms that are the main components of the copper layer facilitate bonding with the copper atoms that are the main components of the metallic phase of the substrate, the copper layer facilitates bonding to the substrate of the composite material. Moreover, the copper layer renders the surface of the substrate smooth. The copper layer also facilitates bonding to heating elements such as semiconductor devices. Therefore, when the heat dissipation member and the heating element are soldered together, voids are unlikely to be formed between the heat dissipation member and the heating element. Therefore, arranging the copper layer on the heating element enables the heating element to be favorably soldered to the heat dissipation member.

[Details of Embodiments of Present Disclosure]

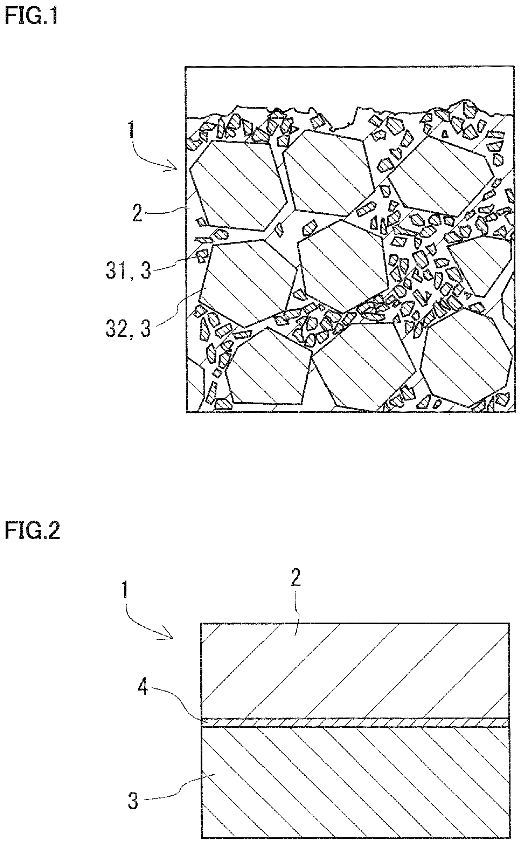

Hereinafter, the composite material and the heat dissipation member according to an embodiment of the present disclosure will be described based on Fig. 1 to Fig. 3. Incidentally, the present invention is not limited to the examples of the embodiments, and is indicated by the claims, and is intended to include all changes within the meaning and scope equivalent to the claims.

<Embodiment 1>

<<Composite Material>>

The composite material 1 of the present embodiment includes a metallic phase 2 and a plurality of particles 3 dispersed in metallic phase 2. Each of the plurality of particles 3 (each particle 3) includes a coating layer 4 on the surface thereof, as shown in Fig. 2. Hereinafter, each configuration of composite material 1 will be described in detail.

(Metallic Phase)

Metallic phase 2 contains Cu as a main element. The main element refers to a metallic element that is the main component of metallic phase 2, i.e., a metallic element that occupies the majority of metallic phase 2. The thermal conductivity of Cu is about 400 W/m·K. Therefore, metallic phase 2 composed mainly of Cu contributes to the improvement on thermal conductivity of composite material 1.

Metallic phase 2 contains the first element and the second element in addition to Cu. The first element is a metallic element having a lower surface tension than Cu. In other words, the surface tension of the molten metal of the first element is lower than that of the molten metal of Cu. The surface tension of metallic elements is publicly known. Specific examples of the first element include at least one selected from the group consisting of Ag, Mg, Al, Sn, Zn, and Mn. The first element is concentrated on the surface of molten metal of metallic phase 2 upon production of composite material 1. The first element concentrated on the surface of molten metal improves the wettability of the molten metal in contact with particles 3 and particles 3.

The second element is at least one selected from the group consisting of Be, Si, Ti, Cr, Zr, Nb, Hf, and Ta. The second element is contained in a predetermined amount in the raw material of composite material 1 upon fabrication of composite material 1. Most of the second element in the raw material is consumed for the formation of coating layer 4 of particles 3. Therefore, the amount of the second element contained in metallic phase 2 is very small.

The contents of the first element and second element in the entire composite material 1 will be described below.

(Particle)

· Materials

Particle 3 is a carbon-based material. The carbon-based material is preferably at least one selected from the group consisting of diamond, graphite, carbon nanotubes, and carbon fibers. Diamond substantially has no anisotropy in terms of thermal conductivity and typically has high thermal conductivity of 1,000 W/m·K or higher. In addition, diamond powder of various particle sizes is commercially available, and diamond powder is readily available. In these points, composite material 1 containing diamond facilitates use as a material for heat dissipation members and is also excellent in manufacturability.

Graphite is soft and excellent in processability. Therefore, composite material 1 containing graphite is excellent in processability. The thermal conductivity along the axial direction in a carbon nanotube may be higher than the thermal conductivity along the axial direction in diamond. Therefore, composite material 1 containing carbon nanotubes is expected to be superior in thermal conductivity. Carbon fibers are excellent in mechanical strength. Therefore, composite material 1 containing carbon fibers is excellent in mechanical strength.

Composite material 1 containing the plurality of carbon-based materials of different types combines the effects that results from each carbon-based material. For example, composite material 1 containing mainly diamond and partially graphite as the carbon-based material is expected to be excellent in thermal conductivity and also to facilitate processing such as cutting.

· Content

Examples of the content of all particles 3 in composite material 1, i.e., the content of the carbon-based powder include 40% by volume or more and 85% by volume or less. If the above content is 40% by volume or more, particles 3 excellent in thermal conductivity are contained more in composite material 1. Therefore, the thermal conductivity of composite material 1 is improved. Moreover, the coefficient of linear expansion of composite material 1 tends to be smaller than that of Cu. The above content being 85% by volume or less facilitates metallic phase 2 to spread into the gaps between particles 3 upon fabrication of composite material 1. The lower limit of the content of particles 3 may be, for example, 45% by volume, further 50% by volume, 55% by volume, or 60% by volume. In addition, the upper limit of the above content may be, for example, 80% by volume, or further 75% by volume or less.

For example, the content of the plurality of particles 3 in composite material 1 is determined as follows. First, the volume of composite material 1 is determined by an Archimedes method. Next, composite material 1 is dissolved in dilute nitric acid to separate carbon-based powder. The mass of the carbon-based powder is measured, and the volume of the carbon-based powder is determined by calculation based on the theoretical density of a carbon-based material constituting the carbon-based powder. Then, the volume of the carbon-based powder is divided by the volume of composite material 1 gives a content of the plurality of particles 3 in composite material 1.

· Size

The average particle size of particles 3 in composite material 1 is preferably, for example, 10 $\mu$m or more and 120 $\mu$m or less. The average particle size of particles 3 may be 15 $\mu$m or more, or even 20 $\mu$m or more. Moreover, the average particle size above may be 100 $\mu$m or less, even 90 $\mu$m or less, 80 $\mu$m or less, 70 $\mu$m or less, or 60 $\mu$m or less.

The average particle size of particles 3 is determined from a circular equivalent diameter obtained by observing the cross section of composite material 1.

Specifically, the circular equivalent diameters of k or more particles 3 in a cross section of composite material 1 are determined. The average of these circular equivalent diameters of k particles is an average particle diameter of particles 3. k is 10 or more. k is preferably 20 or more and more preferably 50 or more. Here, in order to determine the circular equivalent diameter, first a SEM (Scanning Electron Microscope) image of the cross section of composite material 1 is obtained and then the cross sectional area of particle 3 is determined by binarization processing. The diameter of a circle having the same cross sectional area as the cross sectional area is the circular equivalent diameter. The threshold of the binarization processing is adjusted so that each particle 3 can be clearly identified.

The carbon-based powder may be a mixture of a plurality of fine particles 31 and a plurality of coarse particles 32. Composite material 1 fabricated by using the carbon-based powder containing both the fine particles and the coarse particles facilitates composite material 1 with high relative density to be obtained.

Fine particles 31 herein is particle 3 with a circular equivalent diameter of less than 30 $\mu$m determined by observing the cross section of composite material 1. The average particle size of particles 31 is preferably 10 $\mu$m or more and 25 $\mu$m or less. The average particle size is an average of the circular equivalent diameters of n fine particles 31. n is 10 or more. n is preferably 20 or more and more preferably 50 or more.

On the other hand, coarse particle 32 herein is particle 3 with a circular equivalent diameter of 30 $\mu$m or more determined by observing the cross section of composite material 1. The average particle size of coarse particles 32 is preferably 80 $\mu$m or more and 120 $\mu$m or less. The average particle size is an average of the circular equivalent diameters of m coarse particles 32. m is 10 or more. m is preferably 20 or more and more preferably 50 or more.

The volume fraction of the plurality of fine particles 31 based on all particles 3 of the plurality of particles 3 is preferably 20% by volume or more and 50% by volume or less. The volume fractions of fine particles 31 and coarse particles 32 within the above ranges facilitate the sufficient number of fine particles 31 to be arranged between the neighboring coarse particles 32. As a result, the volume of particles 3 based on composite material 1 becomes larger, facilitating the thermal conductivity of composite material 1 to be higher. The volume fraction of particles 31 based on all particles 3 is more preferably 25% by volume or more and 40% by volume or less.

(Coating Layer)

A coating layer 4 covers at least a portion of the surface of each of the plurality of particles 3 and covers typically substantially the entire surface thereof. Coating layer 4 is carbide of the second element. Coating layer 4 improves the wettability between particles 3 and the molten metal of metallic phase 2 upon fabrication of composite material 1. In particular, coating layer 4 composed of titanium carbide contributes to improving the wettability between particles 3 and the molten metal of metallic phase 2.

The thermal conductivity of coating layer 4 is lower than that of Cu and the carbon-based material. Therefore, coating layer 4 is preferably thin to the extent that the improvement effect of wettability above can be obtained. The thickness of coating layer 4 is adjusted with an amount of the second element added or the like upon fabrication of composite material 1. The smaller the aforementioned amount added is, the thinner the thickness of coating layer 4 tends to be.

(Content of First Element in Composite Material)

The content of the first element in composite material 1 is 0.25 atom% or more and 10.0 atom% or less. If the content of the first element is 0.25 atom% or more, the improvement effect of the wettability by the first element can be sufficiently obtained. Therefore, composite material 1 in which the content of the first element is 0.25 atom% or more is excellent in thermal conductivity. In a case in which the content of the first element is 10.0 atom% or less, the decrease in heat resistance of composite material 1 is inhibited. The content of the first element in composite material 1 of the present embodiment is more preferably 0.5 atom% or more and 4.5 atom% or less.

The content of the first element in composite material 1 herein is to be determined by the following formula:

$$\{(\text{the number of atoms of the first element})/(\text{the number of atoms of the main element} + \text{the number of atoms of the first element} + \text{the number of atoms of the second element})\} \times 100$$

The number of atoms of each element in composite material 1 is measured as follows. First, composite material 1 is dissolved by dilute nitric acid, and the solution is filtered to separate particles 3 from the others. The concentration of dilute nitric acid is about 70%. Next, the solution containing metallic phase 2 and coating layer 4 other than particles 3 is then subjected to analysis of ICP emission spectrometry (Inductively Coupled Plasma Atomic Emission Spectrometry). The number of atoms of each element obtained by the analysis is then substituted into the above formula to obtain the content (atom%) of the first element in composite material 1.

(Content of Second Element in Composite Material)

The content of the second element in composite material 1 is 1.5 atom% or more and 14.0 atom% or less. If the content of the second element is 1.5 atom% or more, it can be said that coating layer 4 that is carbide of the second element, is sufficiently present on the surface of each particle 3. Since coating layer 4 is a layer that improves the wettability between metallic phase 2 and particles 3, composite material 1 having a content of 1.5 atom% or more of the second element is excellent in thermal conductivity. On the other hand, if the content of the second element is 14.0 atom% or less, it can be said that coating layer 4 present on the surface of each particle 3 is not too thick. Therefore, composite material 1 having a content of 14.0 atom% or less of the second element is excellent in thermal conductivity. The content of the second element is more preferably 2.5 atom% or more and 10.0 atom% or less.

The content of the second element in composite material 1 herein is to be determined by the formula below. The method for determining the number of atoms of each element is the same as that for determining the content of the first element.

$$\{(\text{the number of atoms of the second element})/(\text{the number of atoms of the main}$$
$$\text{element} + \text{the number of atoms of the first element} + \text{the number of atoms of the}$$
$$\text{second element})\} \times 100$$

(Others)

Composite material 1 may contain a third element to the extent that the thermal conductivity and heat resistance of composite material 1 are not degraded. Examples of the third element include sulfur (S), phosphorus (P), nickel (Ni), cobalt (Co), iron (Fe), and the like. These elements are elements that may be contaminated upon fabrication of composite material 1. The content of the third element in composite material 1 herein is to be determined by the following formula in atomic ratio.

$$\{(\text{the number of atoms of the third element})/(\text{the number of atoms of the main element}$$
$$+ \text{the number of atoms of the first element} + \text{the number of atoms of the second}$$
$$\text{element} + \text{the number of atoms of the third element})\} \times 100$$

The content of the third element is 0 atom% or more and 2.0 atom% or less. With this content of the third element, the thermal conductivity and heat resistance of composite material 1 are not degraded. The composite material of the present embodiment containing the third element can also be specified as follows.

[The composite material including:

a metallic phase; and
a plurality of particles dispersed in the metallic phase, each of the plurality of particles having a coating layer covering a surface of each of the particles, wherein
the plurality of particles is a carbon-based material;
the metallic phase contains a main element, a first element, a second element, and a third element;
the coating layer is carbide of the second element;
the main element is copper;
the first element is a metallic element having a lower surface tension than copper;
the second element is at least one selected from the group consisting of beryllium, silicon, titanium, chromium, zirconium, niobium, hafnium, and tantalum;
the third element is at least one selected from the group consisting of sulfur, phosphorus, nickel, cobalt, and iron;
a content of the first element based on a sum of the main element, the first element, the second element, and the third element is 0.25 atom% or more and 10.0 atom% or less;
a content of the second element based on the sum of the main element, the first element, the second element, and the third element is 1.5 atom% or more and 14.0 atom% or less; and
a content of the third element based on the sum of the main element, the first element, the second element, and the third element is 0 atom% or more and 2.0 atom% or less.]

Here, the bracketed composite material described above includes the following composition.

[The composite material including:

a metallic phase; and
a plurality of particles dispersed in the metallic phase, each of the plurality of particles having a coating layer covering a surface of each of the particles, wherein
each of the particles is a carbon-based material;
components excluding carbon contain
0.25 atom% or more and 10.0 atom% or less of the first element,
1.5 atom% or more and 14.0 atom% or less of the second element, and
0 atom% or more and 2.0 atom% or less of the third element,
with the balance being copper and unavoidable impurities, and wherein
the first element is a metallic element having a lower surface tension than copper;
the second element is at least one selected from the group consisting of beryllium, silicon, titanium, chromium, zirconium, niobium, hafnium, and tantalum; and

the third element is at least one selected from the group consisting of sulfur, phosphorus, nickel, cobalt, and iron.]

(Thermal Conductivity of Composite Material)

The thermal conductivity of composite material 1 of the present embodiment is, for example, 600 W/m·K or more. The higher the thermal conductivity of composite material 1 is, the more preferable it is as a material for heat dissipation members such as semiconductor devices. Therefore, the thermal conductivity of composite material 1 is more preferably 650 W/m·K or more, 660 W/m·K or more, or 700 W/m·K or more.

(Coefficient of Linear Expansion of Composite Material)

As described above, composite material 1 of the present embodiment has an intermediate coefficient of linear expansion between those of the carbon-based material and Cu. Quantitatively, examples of the coefficient of linear expansion of composite material 1 include $4 \times 10^{-6}$/K or more and $15 \times 10^{-6}$/K or less. The more the content of particles 3 in composite material 1, the smaller the coefficient of linear expansion of composite material 1 tends to be. By adjusting the content of particles 3, the coefficient of linear expansion of composite material 1 can be $4.5 \times 10^{-6}$/K or more and $13 \times 10^{-6}$/K or less, or $4.5 \times 10^{-6}$/K or more and $10 \times 10^{-6}$/K or less. If the difference between the coefficient of linear expansion of composite material 1 and the coefficient of linear expansion of a heating element becomes small, composite material 1 bonded to the heating element with a solder or the like will be unlikely to be peeled off from the heating element.

(Relative Density of Composite Material)

In composite material 1 of the present example, the wettability between metallic phase 2 and particles 3 is favorable. Therefore, composite material 1 of the present example has few pores and the relative density of composite material 1 is high. Examples of the relative density of composite material 1 of the present example include 90% or more. The higher the relative density of composite material 1 is, the less likely it is that the thermal conductivity of composite material 1 is lowered due to pores. Therefore, the relative density of composite material 1 is preferably 95% or more, even 96% or more, 97% or more, 98% or more, or 99% or more.

The relative density is the value obtained by diving the actual density of composite material 1 by the theoretical density of composite material 1. The actual density of composite material 1 is obtained by dividing the mass of composite material 1 by the volume thereof. The volume of composite material 1 is obtained by an Archimedes method or the like. On the other hand, the theoretical density of composite 1 herein is obtained according to steps 1 to 5 below.

· Step 1: A volume of composite material 1 is determined by the Archimedes method.
· Step 2: A weight of each element contained in composite material 1 is determined. First, composite material 1 is dissolved in dilute nitric acid, and the weight of particles 3 separated from composite material 1, i.e., the weight of the carbon-based powder is measured. Moreover, a weight of each element contained in the solution of dilute nitric acid is also determined. The weight of each element contained in the solution is determined from the number of atoms of each element obtained by ICP emission spectrometry of the solution.
· Step 3: The weight of each element obtained in Step 2 is divided by the theoretical density of each element to determine a volume of each element in composite material 1. Furthermore, a volume fraction of each element in composite material 1 is calculated based on the volume of each element.
· Step 4: The volume of each element satisfying each volume fraction thereof obtained in Step 3 is calculated, based on the volume of composite material 1 obtained in Step 1.
· Step 5: The volume of each element obtained in Step 4 is multiplied with the theoretical density of each element to calculate a weight of each element in composite material 1. A value obtained by dividing the total weight of each element by the volume of composite material 1 obtained in Step 1 is the theoretical density of composite material 1.

(Applications)

Composite material 1 excellent in thermal conductivity of the present embodiment, is suitable as a material for heat dissipation members. In particular, composite material 1 excellent in consistency of the coefficient of linear expansion thereof with those of semiconductor devices and peripheral parts thereof, is suitable as a material for heat dissipation members for semiconductor devices. Examples of the semiconductor device including the heat dissipation member composed of composite material 1 of the present embodiment include a high-frequency power devices such as LDMOS (Laterally Diffused Metal Oxide Semiconductor). Other semiconductor devices include a semiconductor laser device, a light-emitting diode device, and Central Processing Units of various computers, Graphics Processing Units, High Electron Mobility Transistors (HEMTs), chipsets, memory chips, and the like.

(Effects)

Composite material 1 of the present embodiment is lightweight and inexpensive.

Metallic phase 2 in composite material 1 is mainly composed of Cu. Cu is lighter and less expensive than Ag. Therefore, composite material 1 of the present embodiment is lighter and less expensive than a composite material mainly composed of Ag.

Composite material 1 of the present embodiment is excellent in thermal conductivity and heat resistance. This effect will be described in detail in Test Examples 1 and 2 below.

<<Production Method of Composite Material>>

Composite material of the present embodiment is obtained, for example, by the infiltration method shown below.

First, raw material powder containing the carbon-based powder is filled into a mold. The raw material powder may be, for example, the carbon-based powder singly or a mixture of the carbon-based powder and powder containing the second element to be used as the raw material for coating layer 4.

Next, a copper material to be metallic phase 2 is arranged on top of the raw material powder. The copper material can be powder or small sections. The copper material contains Cu, the first element, and the second element. Here, the raw material powder and the copper material may be mixed and filled into the mold.

The mold in which the raw material powder and the copper material are arranged is heated to melt the copper material. As a result, the molten metal of the copper material is infiltrated to the raw material powder, and the raw material powder and the molten metal of the copper material are composited.

The infiltration temperature, i.e., the heating temperature of the raw material powder and the copper material, is a temperature higher than the melting point of Cu at which the copper material can be melted. For example, the infiltration temperature is 1100°C or more, or even 1150°C or more. However, in the case of the infiltration temperature being excessively high, Cu and the like contained in the copper material are likely to be oxidized in the course of temperature rise. Therefore, the infiltration temperature is preferably 1300°C or less.

The holding time of the infiltration temperature varies depending on the size of composite material 1. For example, the holding time of the infiltration temperature is, for example, approximately 10 minutes or more and 120 minutes or less.

The atmosphere upon infiltration is a vacuum atmosphere of 1 Pa or less, a reducing atmosphere, or an inert atmosphere. The aforementioned vacuum atmosphere, reducing atmosphere, or inert atmosphere reduces oxidation of Cu and the like. The pressure of the vacuum atmosphere is 0.1 Pa or less, and even 0.01 Pa or less. The inert atmosphere includes an inert gas atmosphere such as argon or nitrogen. The reducing atmosphere includes a hydrogen atmosphere or a mixed atmosphere of hydrogen and an inert gas. In both atmospheres, the oxygen concentration is preferably low.

Upon infiltration, the molten metal incorporates the second element contained in the raw powder and contacts particles 3, forming coating layer 4 on the surface of particles 3. Coating layer 4 improves the wettability between particles 3 and the molten metal. In addition, on the surface of the molten metal in contact with particles 3, the first element is concentrated, and the concentrated first element improves the wettability between particles 3 and the molten metal. As a result, particles 3 and the molten metal are composited. At this time, voids are unlikely to be formed in the vicinity of particles 3.

Following the infiltration of metallic phase 2, the raw material in the mold is cooled. By cooling the raw material, a composite material 1 in which the plurality of particles 3 with coating layer 4 are dispersed in metallic phase 2 composed mainly of Cu, is obtained.

<Embodiment 2>

«Heat Dissipation Member»

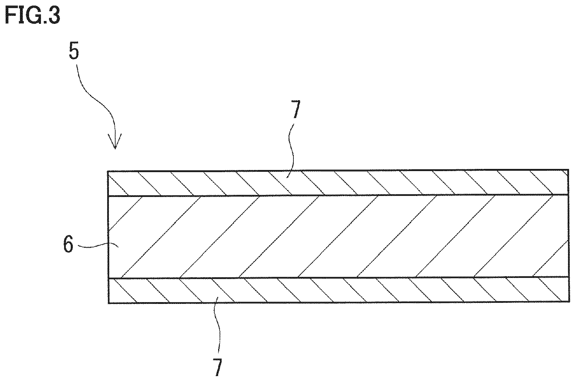

A heat dissipation member 5 shown in Fig. 3 is an example of the heat dissipation member using composite material 1 of the present embodiment. Heat dissipation member 5 in Fig. 3 includes a substrate 6 and a copper layer 7. Substrate 6 is composed of composite material 1. Copper layer 7 is arranged on at least a portion of substrate 6. In this example, copper layer 7 is arranged on each of the first surface and the second surface of substrate 6.

The copper atoms that are the main components of copper layer 7 facilitate bonding with the copper atoms that are the main component of metallic phase 2 in composite material 1 constituting substrate 6, and thereby copper layer 7 is unlikely to be delaminated from substrate 6. Moreover, copper layer 7 renders the surface of heat dissipation member 5 smooth, whereby when heat dissipation member 5 including copper layer 7 is soldered to a heating element such as a semiconductor device, voids are unlikely to be formed between heat dissipation member 5 and the heating element. Therefore, the heating element facilitates heat transfer to heat dissipation member 5, inhibiting the temperature rise of the heating element.

Copper layer 7 is formed by bonding a copper foil to the surface of substrate 6 with a solder material such as an Ag-Cu alloy. In addition, copper layer 7 may be formed by vapor deposition or Cu plating. A plating layer may be further disposed on the surface of copper layer 7. The material of the plating layer is, for example, nickel (Ni).

<Test Example 1>

In Test Example 1, the effects of the contents of the first element and the second element in the composite material on the thermal conductivity and heat resistance of the composite material were investigated.

<<Fabrication of Samples>>

In Test Example 1, the composite materials of sample No. 1 to sample No. 28 in which the particles were diamond, the first element was Ag, and the second element was Ti were fabricated. The specific fabrication procedure is as follows.

First, raw powder of diamond powder containing Ti as the second element was prepared. A copper material containing Ag as the first element and Ti as the second element, was also prepared. The raw material powder was filled into a carbon mold, and the copper material was filled on top of the filling. The raw material powder and the copper material were then heat-treated in an argon atmosphere together with the entire mold to composite the diamond powder and molten metal. The heat treatment temperature was any temperature from 1100°C to 1200°C, and the heat treatment time was any time from 10 minutes to 120 minutes. After the heat treatment, the mold was cooled to obtain the composite material.

<<Measurement Items>>

The composition and properties of the composite materials of sample Nos. 1 to 28 obtained by the fabrication procedure above were measured. The results are shown in Table 1. The composite material of the sample with "∗" or "∗∗" after the sample number in Table 1 is such that the composite material satisfies the requirements of composite material 1 according to Embodiment 1. The measurement items in Test Example 1 are as follows.

(Thermal Conductivity)

The thermal conductivity (W/m·K) of the composite material of each sample was measured. Thermal conductivity was measured using a measurement apparatus commercially available (NETZSCH LFA467) at room temperature by the Flash Method. The measurement conditions were complied with ASTM E1461-13 "Standard Test Method for Thermal Diffusivity by the Flash Method." Here, the thermal conductivity of sample Nos. 22 and 23 was not measured because each molten metal was not infiltrated to the diamond particles.

(Heat Resistance)

The heat resistance of the composite material of each sample was investigated. Specifically, the composite material of each sample was heat-treated at 800°C for 30 minutes, and whether melting marks appeared on the surface of the composite material was visually observed. The composite material with melting marks is a composite material not sufficient in heat resistance. The composite material without melting marks is a composite material excellent in heat resistance. In Table 1, "no good" indicates insufficient heat resistance and "good" indicates excellent heat resistance. The heat resistance of sample Nos. 22 and 23, in which each molten metal was not infiltrated into the diamond particles, was not investigated.

(Average Particle Size of Particles)

The cross section of the composite material of each sample was observed, and the average particle size of the diamond particles contained in the composite material was investigated. Specifically, a SEM photograph of the cross section of the composite material was obtained, and each diamond particle was identified by image analysis as well as a circular equivalent diameter of each diamond particle was determined. The diamond particle with a circular equivalent diameter of less than 30 $\mu$m was defined as a fine particle, and the diamond particle with a circular equivalent diameter of 30 $\mu$m or more was defined as a coarse particle. The average particle size of fine particles is the average value of the circular equivalent diameters of diamond particles that were determined to be fine particles. The average particle size of the coarse particles is an average value of the circular equivalent diameters of diamond particles that were determined to be coarse particles. Here, the diamond particles with a cross-sectional area of 3 $\mu$m$^2$ or less in the SEM photograph were not included in the calculation of average value of fine particles.

(Volume Fractions of Fine Particles and Coarse Particles)

The volume fractions (% by volume) of the fine particles and the coarse particles were determined from the SEM photographs. Specifically, the total area of fine particles and the total area of coarse particles in the SEM photograph were determined, and the area ratios of the fine particles and the coarse particles were considered to be volume fractions of the fine particles and the coarse particles. For example, if a total area of the fine particles obtained from the SEM photograph was 3000 $\mu$m$^2$ and a total area of the coarse particles is 7000 $\mu$m$^2$, then the volume fraction of the fine particles in all the particles is 30% by volume and the volume fraction of coarse particles is 70% by volume.

(Content of Particles in Composite Material)

The content (%) of particles in the composite material was determined as follows. First, the volume of the composite material in each sample was determined by the Archimedes method. Next, the composite material was dissolved in 70% dilute nitric acid, and the solution was filtered to separate the diamond powder. The mass of the separated diamond powder was measured, and the volume of the diamond powder was determined by calculation based on the theoretical density of diamond. The volume of the diamond powder was divided by the volume of the composite material to obtain a content of particles in the composite material.

(Content of Ag in Composite Material)

The content of Ag (atom%) in the metallic phase and the coating layer was determined. The content of Ag as the first element was determined by ICP emission spectrometry of the solution of the composite material dissolved in dilute nitric acid. The content of Ag is the ratio of the number of atoms of Ag based on the total number of atoms of Cu, Ag, and Ti in the solution.

(Content of Ti in Composite Material)

The content of Ti (atom%) in the metallic phase and the coating layer was measured. The content of Ti as the second element was determined by ICP emission spectrometry of the solution of the composite material dissolved in dilute nitric acid. The content of Ti is the ratio of the number of atoms of Ti based on the total number of atoms of Cu, Ag, and Ti in the solution.

(Relative Density of Composite Material)

The relative density (%) of the composite material was determined by the method described above in the "Relative Density of Composite Material" section. First, the mass of the composite material of each sample was measured and the volume of the composite material of each sample was determined by the Archimedes method. The actual density of the composite material of each sample was determined by dividing the mass thereof measured by the volume. Next, the theoretical density of the composite material for each sample was determined, and the relative density of the composite material was obtained by dividing the actual density of composite material 1 by the theoretical density of composite material 1. The theoretical density of the composite materials was determined according to Steps 1 to 5 described in the "Relative Density of Composite Material" section.

[Table 1]

| Sample No. | Particles | | | | | Metallic phase + Coating layer | | Relative density | Thermal conductivity | Heat resistance |
| | Fine particles | | Coarse particles | | Content of particles | Ti/(Cu+Ag+Ti) | Ag/(Cu+Ag+Ti) | | | |
| | Average particle size | Volume fraction | Average particle size | Volume fraction | | | | | | |
| | [μm] | [vol%] | [μm] | [vol%] | [vol%] | [at%] | [at%] | [%] | [W/m·K] | |
|---|---|---|---|---|---|---|---|---|---|---|
| 1 ** | 16 | 28 | 101 | 72 | 62.2 | 2.86 | 2.32 | 99.0 | 667.2 | good |
| 2 ** | 17 | 26 | 103 | 74 | 71.9 | 6.28 | 3.17 | 99.4 | 697.6 | good |
| 3 * | 14 | 32 | 78 | 68 | 79.6 | 13.31 | 0.26 | 96.7 | 610.4 | good |
| 4 ** | 12 | 31 | 101 | 69 | 78.0 | 7.16 | 0.55 | 99.0 | 693.9 | good |
| 5 * | 14 | 100 | - | 0 | 52.5 | 2.16 | 1.46 | 95.1 | 605.3 | good |
| 6 * | 16 | 100 | - | 0 | 50.6 | 2.03 | 4.79 | 98.3 | 607.8 | good |
| 7 * | 25 | 100 | - | 0 | 56.2 | 2.13 | 9.26 | 98.9 | 625.3 | good |
| 8 * | 15 | 28 | 105 | 72 | 78.6 | 8.97 | 8.55 | 98.2 | 642.9 | good |
| 9 * | 18 | 25 | 101 | 75 | 80.5 | 13.61 | 7.59 | 99.3 | 615.8 | good |
| 10 ** | 14 | 28 | 107 | 72 | 70.2 | 8.00 | 4.27 | 99.2 | 680.7 | good |
| 11 ** | 18 | 35 | 105 | 65 | 67.5 | 8.30 | 2.77 | 99.6 | 669.4 | good |
| 12 * | 5 | 28 | 42 | 72 | 78.5 | 12.68 | 1.83 | 99.4 | 620.9 | good |
| 13 * | 13 | 25 | 97 | 75 | 81.3 | 10.60 | 5.52 | 99.0 | 645.1 | good |
| 14 * | 15 | 27 | 104 | 73 | 74.4 | 5.55 | 7.30 | 99.6 | 649.8 | good |
| 15 ** | 17 | 29 | 106 | 71 | 75.6 | 9.32 | 0.59 | 99.6 | 671.0 | good |
| 16 ** | 19 | 29 | 110 | 71 | 78.9 | 3.26 | 0.98 | 99.8 | 720.9 | good |
| 17 ** | 15 | 100 | - | 0 | 53.6 | 3.45 | 4.18 | 99.1 | 662.0 | good |
| 18 ** | 18 | 24 | 107 | 76 | 76.1 | 9.95 | 3.84 | 99.2 | 670.8 | good |
| 19 ** | 18 | 32 | 103 | 68 | 72.8 | 5.90 | 1.92 | 99.5 | 700.4 | good |
| 20 | 17 | 26 | 100 | 74 | 78.4 | 8.64 | 10.76 | 98.3 | 585.6 | no good |
| 21 | 17 | 100 | - | 0 | 50.7 | 0.76 | 11.01 | 78.3 | 344.2 | no good |

(continued)

| Sample No. | Particles | | | | | Metallic phase + Coating layer | | Relative density | Thermal conductivity | Heat resistance |
|---|---|---|---|---|---|---|---|---|---|---|
| | Fine particles | | Coarse particles | | Content of particles | Ti/ (Cu+Ag+Ti) | Ag/ (Cu+Ag+Ti) | | | |
| | Average particle size | Volume fraction | Average particle size | Volume fraction | | | | | | |
| | [μm] | [vol%] | [μm] | [vol%] | [vol%] | [at%] | [at%] | [%] | [W/m·K] | |
| 22 | 16 | 100 | - | 0 | 52.5 | 0.73 | 7.67 | - | - | - |
| 23 | 23 | 100 | - | 0 | 54.5 | 0.75 | 0.14 | - | - | - |
| 24 | 15 | 28 | 102 | 72 | 74.5 | 12.61 | 0.08 | 85.4 | 382.7 | good |
| 25 | 19 | 25 | 103 | 75 | 79.5 | 17.13 | 2.81 | 99.7 | 429.8 | good |
| 26 | 16 | 26 | 104 | 74 | 77.5 | 16.49 | 5.42 | 99.3 | 452.3 | good |
| 27 | 17 | 28 | 106 | 72 | 73.4 | 15.72 | 9.87 | 99.8 | 420.5 | good |
| 28 | 18 | 27 | 96 | 73 | 75.2 | 7.02 | 55.77 | 99.4 | 553.8 | no good |

As shown in Table 1, each of the composite materials of sample No. 1 to sample No. 19, in which the content of Ag in the composite material was 0.25 atom% or more and 10.0 atom% or less and the content of Ti was 1.5 atom% or more and 14.0 atom% or less, had thermal conductivity of 600 W/m·K or more and included favorable heat resistance. In particular, each of the composite materials of sample Nos. 1, 2, 4, 10, 11, 15 to 19, in which the content of Ag was 0.5 atom% or more and 4.5 atom% or less and the content of Ti was 2.5 atom% or more and 10.0 atom% or less, had thermal conductivity of 660 W/m·K or more and included favorable heat resistance.

The composite materials of sample Nos. 20, 21, 28, in which the contents of Ag in the composite materials were more than 10.0 atom% had low heat resistance. This is conjectured because the content of Ag in the metallic phase was excessive and a portion of the metallic phase was melted by heat treatment at 800°C.

In sample Nos. 22 and 23, in which the contents of Ti in the composite materials were less than 1.5 atom%, each molten metal was not sufficiently infiltrated into the diamond particles, whereby no composite materials were formed. On the other hand, in sample No. 21, the content of Ti was low, however the content of Ag was high, whereby the molten metal was infiltrated into the diamond particles. This indicates that the presence of Ag in the molten metal plays a major role in improving the wettability between the diamond particles and the molten metal.

In sample No. 24, although the content of Ag was less than 0.25 atom%, the molten metal was sufficiently infiltrated into the diamond particles. This is conjectured because the content of Ti in sample No. 24 was relatively high and a thick coating layer was formed on the surface of the diamond particles. The thick coating layer improves the wettability between the diamond particles and molten metal, however, decreases the thermal conductivity of the composite material. In fact, the thermal conductivity of sample No. 24 was approximately 400 W/m·K.

The composite materials of sample Nos. 25 to 27, in which the contents of Ti in the composite materials were more than 14.0 atom%, had the thermal conductivity of approximately 400 W/m·K. The large content of Ti results in high thickness of the coating layer. Therefore, the thermal conductivity of the composite materials of sample Nos. 25 to 27 was conjectured to be reduced due to the presence of the thick coating layer.

The results of the comparison between sample Nos. 5 to 7, 17 and sample Nos. 1 to 4, 8 to 16, 18, 19 in Table 1 demonstrated that the diamond powder being a mixture of the fine particles and the coarse particles enhanced the content of particles in the composite material.

<Test Example 2>

In Test Example 2, the composite materials of sample Nos. 30 to 39 were fabricated by varying the first elements and second elements, and the thermal conductivity and heat resistance of each sample were investigated. The measurement items and methods of Test Example 2 are the same as those of Test Example 1. The measurement results of sample Nos. 30 to 39 are shown in Table 2.

The first element in Test Example 2 was any of Ag, Mg, Al, Sn, Zn, or Mn. In addition, the second element was any of Ti, Zr, Cr, Si, Ta, or Nb. In Table 2, the first element is denoted as "$\alpha$" and the second element as "$\beta$".

[Table 2]

| Sample No. | α | β | Particles | | | | | Metallic phase + Coating layer | | Relative density | Thermal conductivity | Heat resistance |
|---|---|---|---|---|---|---|---|---|---|---|---|---|
| | | | Fine particles | | Coarse particles | | Content of particles | β/ (Cu+α +β) | α/ (Cu+α+β ) | | | |
| | | | Average particle size | Volume fraction | Average particle size | Volume fraction | | | | | | |
| | | | [μm] | [vol%] | [μm] | [vol%] | [vol%] | [at%] | [at%] | [%] | [W/m·K] | |
| 30 | Mg | Ti | 16 | 28 | 101 | 72 | 71.0 | 7.59 | 3.84 | 98.5 | 630.5 | good |
| 31 | Al | Ti | 15 | 30 | 101 | 70 | 71.9 | 6.62 | 4.16 | 96.4 | 652.8 | good |
| 32 | Sn | Ti | 16 | 31 | 103 | 69 | 74.3 | 6.88 | 3.32 | 95.7 | 648.5 | good |
| 33 | Zn | Ti | 17 | 32 | 102 | 68 | 76.2 | 5.89 | 4.40 | 97.2 | 638.1 | good |
| 34 | Mn | Ti | 15 | 28 | 97 | 72 | 69.3 | 6.88 | 3.47 | 96.0 | 648.5 | good |
| 35 | Ag | Zr | 15 | 28 | 98 | 72 | 68.9 | 3.19 | 2.04 | 95.8 | 651.2 | good |
| 36 | Ag | Cr | 14 | 24 | 100 | 76 | 72.9 | 6.93 | 2.41 | 97.4 | 667.5 | good |
| 37 | Ag | Si | 18 | 22 | 99 | 78 | 74.0 | 9.56 | 2.28 | 98.6 | 645.5 | good |
| 38 | Ag | Ta | 14 | 28 | 106 | 72 | 71.9 | 2.88 | 1.74 | 99.3 | 656.4 | good |
| 39 | Ag | Nb | 16 | 29 | 105 | 71 | 71.5 | 3.50 | 2.28 | 97.2 | 652.7 | good |

As shown in Table 2, the composite materials of sample Nos. 30 to 39 included excellent thermal conductivity and heat resistance. From this result, it was found that Mg, Al, Sn, Zn, and Mn functioned effectively as the first element in place of Ag. Moreover, it was found that Zr, Cr, Si, Ta, and Nb functioned effectively as the second element in place of Ti.

REFERENCE SIGNS LIST

1 composite material, 2 metallic phase, 3 particle, 31 fine particle, 32 coarse particle, 4 coating layer, 5 heat dissipation member, 6 substrate, 7 copper layer.

**Claims**

1. A composite material comprising:

   a metallic phase; and
   a plurality of particles dispersed in the metallic phase, each of the plurality of particles having a coating layer covering a surface of each of the particles, wherein
   the plurality of particles is a carbon-based material;
   the metallic phase comprises a main element, a first element, and a second element;
   the coating layer is carbide of the second element;
   the main element is copper;
   the first element is a metallic element having a lower surface tension than copper;
   the second element is at least one selected from the group consisting of beryllium, silicon, titanium, chromium, zirconium, niobium, hafnium, and tantalum;
   a content of the first element based on a sum of the main element, the first element, and the second element is 0.25 atom% or more and 10.0 atom% or less, and
   a content of the second element based on a sum of the main element, the first element, and the second element is 1.5 atom% or more and 14.0 atom% or less.

2. The composite material according to claim 1, wherein the carbon-based material is diamond.

3. The composite material according to claim 1 or 2, wherein the first element is at least one selected from the group consisting of silver, magnesium, aluminum, tin, zinc, and manganese.

4. The composite material according to claim 3, wherein the first element is silver.

5. The composite material according to any one of claims 1 to 4, wherein the second element is titanium.

6. The composite material according to any one of claims 1 to 5, wherein a content of the plurality of particles is 40% by volume or more and 85% by volume or less.

7. The composite material according to any one of claims 1 to 6, wherein the plurality of particles comprises a plurality of fine particles and a plurality of coarse particles,

   each of the plurality of fine particles has a particle size of less than 30 $\mu$m,
   each of the plurality of coarse particles has a particle size of 30 $\mu$m or larger, and
   a volume fraction of the plurality of fine particles based on all particles of the plurality of particles is 20% by volume or more and 50% by volume or less.

8. A heat dissipation member, comprising:

   a substrate composed of the composite material according to any one of claims 1 to 7; and
   a copper layer covering at least a portion of a surface of the substrate.

FIG.1

FIG.2

FIG.3

**INTERNATIONAL SEARCH REPORT**

| International application No. |
| --- |
| PCT/JP2021/008634 |

**A. CLASSIFICATION OF SUBJECT MATTER**
Int. Cl. C22C9/00(2006.01)i, C22C26/00(2006.01)i
FI: C22C26/00 Z, C22C9/00

According to International Patent Classification (IPC) or to both national classification and IPC

**B. FIELDS SEARCHED**

Minimum documentation searched (classification system followed by classification symbols)
Int. Cl. C22C9/00, C22C26/00

Documentation searched other than minimum documentation to the extent that such documents are included in the fields searched
Published examined utility model applications of Japan     1922-1996
Published unexamined utility model applications of Japan   1971-2021
Registered utility model specifications of Japan           1996-2021
Published registered utility model applications of Japan   1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 11-67991 A (SUMITOMO ELECTRIC INDUSTRIES, LTD.) | 1-6, 8 |
| A | 09 March 1999, paragraphs [0068]-[0072], [0078] | 7 |
| A | JP 2007-535151 A (PLANSEE SE) 29 November 2007, claim 12 | 7 |
| A | WO 03/040420 A1 (SUMITOMO ELECTRIC INDUSTRIES, LTD.) 15 May 2003, claims | 1-8 |
| A | JP 2004-197153 A (ALLIED MATERIAL CORP.) 15 July 2004, paragraph [0013], claims | 1-8 |

☐ Further documents are listed in the continuation of Box C.  ☒ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 27.04.2021 | 11.05.2021 |

| Name and mailing address of the ISA/ | Authorized officer |
| --- | --- |
| Japan Patent Office 3-4-3, Kasumigaseki, Chiyoda-ku, Tokyo 100-8915, Japan | |
| | Telephone No. |

Form PCT/ISA/210 (second sheet) (January 2015)

INTERNATIONAL SEARCH REPORT

Information on patent family members

International application No.

PCT/JP2021/008634

| Patent Documents referred to in the Report | Publication Date | Patent Family | Publication Date |
|---|---|---|---|
| JP 11-67991 A | 09.03.1999 | US 6031285 A examples 8, 9, 12 | |
| JP 2007-535151 A | 29.11.2007 | US 2007/0042895 A1 claim 12 | |
| WO 03/040420 A1 | 15.05.2003 | US 2005/0051891 A1 claims | |
| JP 2004-197153 A | 15.07.2004 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020053219 A
- JP 2004197153 A
- WO 2016035795 A
- WO 2019163721 A